# EUROPEAN PATENT APPLICATION

(11) **EP 4 660 648 A1**
(43) Date of publication of application: **10.12.2025**
(21) Application number: 23926553.1
(22) Date of filing: 28.12.2023
(51) Int. Cl.: G01R 31/385, G01R 19/165, G01R 31/396, G01R 31/367

(54) **BATTERY DIAGNOSIS DEVICE AND BATTERY DIAGNOSIS METHOD**

(30) Priority: 03.03.2023 KR 20230028776
(71) Applicant: LG Energy Solution, Ltd., Seoul 07335 (KR)
(72) Inventor: LEE, Seung Hyun, Daejeon 34122 (KR); LEE, Bom Jin, Daejeon 34122 (KR)
(74) Representative: Plasseraud IP
(86) International application number: PCT/KR2023/021908
(87) International publication number: WO 2024/185981

(57) **Abstract**

A battery diagnosis apparatus includes an information obtaining unit configured to obtain current data of a battery cell and a controller configured to obtain the current data in a constant voltage charging period of the battery cell, set a first timepoint at which the current data is obtained and a second timepoint at which the current data is obtained after an elapse of a predetermined time from the first timepoint, and determine a state of the battery cell based on current values at the first timepoint and the second timepoint.

## Description

### [Technical Field]

### CROSS-REFERENCE TO RELATED APPLICATION

This application claims priority to and the benefit of Korean Patent Application No. 10-2023-0028776 filed in the Korean Intellectual Property Office on March 3, 2023, the entire content of which is incorporated herein by reference.

### TECHNICAL FIELD

Embodiments disclosed herein relate to a battery diagnosis apparatus and method.

### [Background Art]

Recently, devices for stably supplying and managing power, such as portable devices like smartphones or laptop computers, electric vehicles or electric kickboards, transport means like electric two-wheel vehicles, and energy storage systems (ESS) have been widely used, interests in batteries are increasing and development of the batteries is becoming more active.

Batteries refer to components for supplying power to systems, etc. In this case, the battery may be used such that one secondary battery supplies power to a battery cell alone or a plurality of secondary batteries form one battery module or one battery bank to supply power.

Meanwhile, the battery may have a defect for various reasons. For example, lithium (Li) ions is precipitated inside the battery, and current is supplied to the precipitated lithium, and the battery may generate heat.

### [Disclosure]

### [Technical Problem]

Embodiments disclosed herein aim to provide a battery diagnosis apparatus and a battery diagnosis method to diagnose a battery.

Technical problems of the embodiments disclosed herein are not limited to the above-described technical problems, and other unmentioned technical problems would be clearly understood by those skilled in the art in the technical field to which the present disclosure pertains from the following description.

### [Technical Solution]

A battery diagnosis apparatus according to an embodiment disclosed herein includes an information obtaining unit configured to obtain current data of a battery cell and a controller configured to obtain the current data in a constant voltage charging period of the battery cell, set a first timepoint at which the current data is obtained and a second timepoint at which the current data is obtained after an elapse of a predetermined time from the first timepoint, and determine a state of the battery cell based on current values at the first timepoint and the second timepoint.

According to an embodiment, the controller may be further configured to determine the battery cell is an abnormal battery cell if the current value at the second timepoint is greater than the current value at the first timepoint.

According to an embodiment, the controller may be further configured to change the first timepoint and the second timepoint while maintaining a time interval between the first timepoint and the second timepoint and compare the current value at the first timepoint with the current value at the second timepoint.

According to an embodiment, the abnormal battery cell may include a battery cell in which lithium (Li) is precipitated.

According to an embodiment, the controller may be further configured to classify the current data into a direct current component and an alternating current component by using a moving average of the current data.

According to an embodiment, the controller may be further configured to remove the direct current component from the current data to extract the alternating current component.

According to an embodiment, the controller may be further configured to calculate a standard deviation of the alternating current component, and set the time interval between the first timepoint and the second timepoint based on the standard deviation.

According to an embodiment, the battery diagnosis apparatus may further include a storing unit configured to store the current data of the battery cell, measured by the information obtaining unit.

A battery diagnosis method according to an embodiment disclosed herein includes obtaining current data of a battery cell in a constant voltage charging period of the battery cell, setting a first timepoint at which the current data is obtained and a second timepoint at which the current data is obtained after an elapse of a predetermined time from the first timepoint, and determining a state of the battery cell based on current values at the first timepoint and the second timepoint.

According to an embodiment, he determining of the state of the battery cell may include determining the battery cell is an abnormal battery cell if the current value at the second timepoint is greater than the current value at the first timepoint.

According to an embodiment, the abnormal battery cell may include a battery cell in which lithium (Li) is precipitated.

According to an embodiment, the determining of the state of the battery cell may include generating, based on the current data, a graph in which a first axis is time and a second axis is a current value, changing the first timepoint and the second timepoint while maintaining a time interval between the first timepoint and the second timepoint, and comparing the current value at the first timepoint with the current value at the second timepoint.

According to an embodiment, the setting of the time interval may include classifying the current data into a direct current component and an alternating current component by using a moving average of the current data.

According to an embodiment, the setting of the time interval may include removing the direct current component from the current data to extract the alternating current component.

According to an embodiment, the setting of the time interval may include calculating a standard deviation of the alternating current component, and setting the time interval between the first timepoint and the second timepoint based on the standard deviation.

Detailed matters of other embodiments are included in a detailed description and drawings.

### [Advantageous Effects]

The battery diagnosis apparatus and the battery diagnosis method according to embodiments disclosed herein may diagnose a state of a battery based on current data of the battery.

The battery diagnosis apparatus and the battery diagnosis method according to embodiments disclosed herein may diagnose lithium precipitation inside the battery, thereby early detecting an abnormal battery and preventing heat generation and fire of the battery in advance.

### [Description of Drawings]

FIG. 1 is a block diagram of a battery pack according to an embodiment disclosed herein.
FIG. 2 is a view of a battery diagnosis apparatus according to an embodiment disclosed herein.
FIG. 3 is a graph of current of a battery cell, generated by a battery diagnosis apparatus according to an embodiment disclosed herein, over time.
FIG. 4 shows current data of a region A of FIG. 3 and a moving average line of the current data together.
FIG. 5 shows a difference between current data and a moving average line of FIG. 4.
FIG. 6 is a flowchart of a battery diagnosis method according to an embodiment disclosed herein.
FIG. 7 is a flowchart showing in detail an operation of determining a state of a battery cell based on current values at a first timepoint and a second timepoint of FIG. 6.
FIG. 8 illustrates a computing system that executes a battery diagnosis method, according to an embodiment disclosed herein.

### [Mode for Invention]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

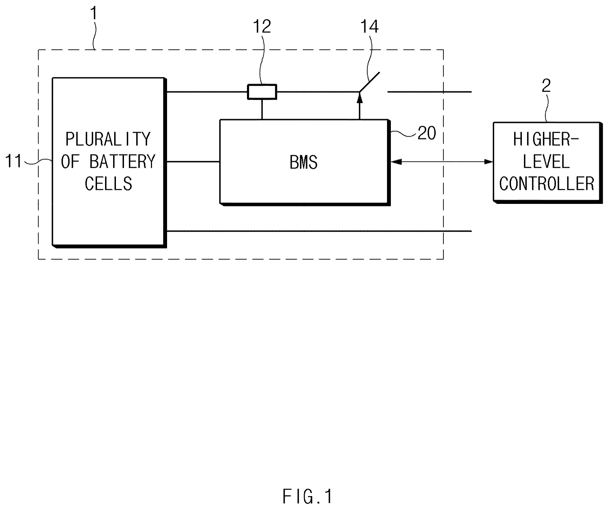

FIG. 1 is a block diagram of a battery pack according to an embodiment disclosed herein.

Referring to FIG. 1, a battery control system including a battery pack 1 and a higher-level controller 2 included in a higher-level system according to an embodiment disclosed herein is schematically shown.

As shown in FIG. 1, the battery pack 1 may include one or more battery cells 11, a switching unit 14 serially connected to a first terminal side and/or a second terminal side of the battery cell 11 to control a charging/discharging current flow of the battery cell 11, and a battery management system 20 for management to prevent over-charging and over-discharging by monitoring a voltage, a current, a temperature, etc., of the battery pack 1.

In this case, the battery pack 1 may include the battery cell 11, the sensor 12, the switching unit 14, and the battery management system 20 provided in plural. For example, the first terminal may be a positive (+) terminal of the battery cell 11, and the second terminal may be a negative (-) terminal.

Herein, as the switching unit 14 which is an element for controlling a current flow for charging or discharging of the plurality of battery cells 11, for example, at least one relay, magnetic contactor, etc., may be used according to specifications of the battery pack 1.

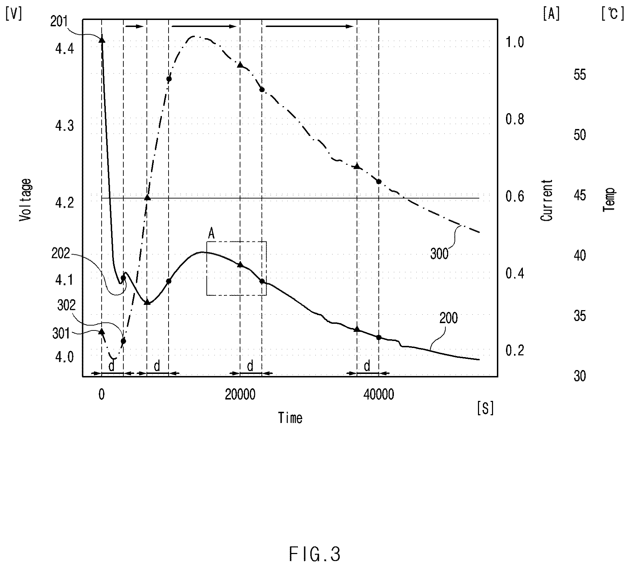

The plurality of battery cells 11 may include cylindrical batteries. The cylindrical batteries refer to batteries in which battery materials are packaged into a cylinder. As the plurality of battery cells 11 include cylindrical batteries, current flowing through the battery cells 11 may increase in case of occurrence of lithium precipitation inside the cylindrical batteries during constant voltage charging of the battery cells 11. This phenomenon may originate from heat generation due to lithium precipitation and leakage current amount increase inside the cylindrical batteries. This will be described in detail with reference to FIG. 3.

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the battery cell 11 to monitor the state of each battery cell 11.

The higher-level controller 2 may transmit a control signal regarding the battery cell 11 to the battery management system 20. Thus, the battery management system 20 may also be controlled in terms of an operation thereof based on a signal applied from the higher-level controller 2.

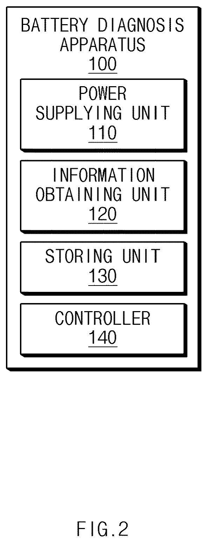

According to an embodiment, the battery management system 20 may include a battery diagnosis apparatus 100 of FIG. 2. According to another embodiment, the battery management system 20 may be different from the battery diagnosis apparatus 100 of FIG. 2. That is, the battery diagnosis apparatus 100 of FIG. 2 may be included in the battery pack 1 and may be configured as another device outside the battery pack 1. Hereinbelow, for convenience of description, it is assumed that the battery diagnosis apparatus 100 includes another device outside the battery pack 1. The following operation of the battery diagnosis apparatus 100 may also be performed in various devices such as not only a battery management system (BMS) in a vehicle, but also a server, a cloud, a charger, a charger/discharger, etc.

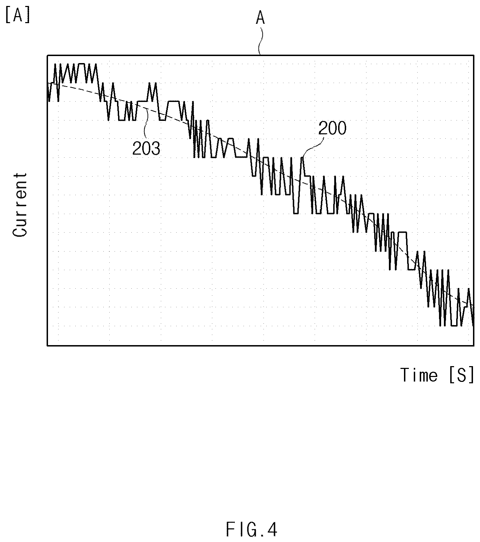

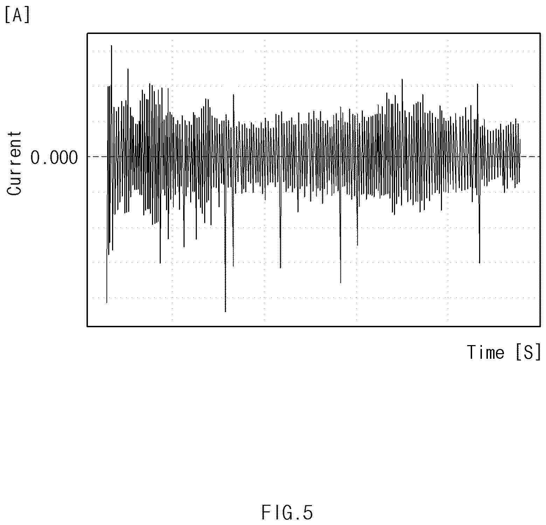

FIG. 2 is a view of a battery diagnosis apparatus according to an embodiment disclosed herein. FIG. 3 is a graph of current of a battery cell, generated by a battery diagnosis apparatus according to an embodiment disclosed herein, over time. FIG. 4 shows current data of a region A of FIG. 3 and a moving average line of the current data together. FIG. 5 shows a difference between current data and a moving average line of FIG. 4.

Referring to FIG. 2, the battery diagnosis apparatus 100 according to an embodiment disclosed herein may include a power supplying unit 110, an information obtaining unit 120, a storing unit 130, and a controller 140.

The power supplying unit 110 may charge/discharge the battery cell 11. The power supplying unit 110 may supply voltage and current to the battery cell 11 to charge/discharge the battery cell 11. According to an embodiment, the power supplying unit 110 may supply a constant current to the battery cell 11 and increase a voltage of the battery cell 11. The battery cell 11 may be charged by being supplied with current by the power supplying unit 110. A period in which the battery cell 11 is supplied with a constant current from the power supplying unit 110 may be defined as a constant current charging period.

As the voltage of the battery cell 11 reaches a specific value, the power supplying unit 110 may maintain the voltage of the battery cell 11 constant and gradually reduce the amount of current supplied to the battery cell 11 to charge the battery cell 11. In this way, the remaining capacity by which the battery cell 11 is not charged in the constant current charging period may be charged. A period in which the battery cell 11 is supplied with a constant voltage from the power supplying unit 110 may be defined as a constant voltage charging period. The power supplying unit 110 may be connected to the battery cell 11 to supply voltage and current to the battery cell 11.

The information obtaining unit 120 may obtain data of the battery cell 11. According to an embodiment, the information obtaining unit 120 may obtain voltage data, current data, and temperature data of the battery cell 11 over time. That is, the information obtaining unit 120 may measure a voltage at opposite terminals of the battery cell 11, a current flowing to the battery cell 11, and a temperature of the battery cell 11. To this end, the information obtaining unit 120 may be connected to the battery cell 11.

The information obtaining unit 120 may transfer the voltage data, the current data, and the temperature data of the battery cell 11 to the storing unit 130 or the controller 140.

The storing unit 130 may receive, from the information obtaining unit 120, and store the voltage data, current data, and temperature data of the battery cell 11. According to an embodiment, the storing unit 130 may transfer the voltage data, the current data, and the temperature data of the battery cell 11 to the controller 140.

The controller 140 may diagnose the state of the battery cell 11. That is, the controller 140 may determine the state of the battery cell 11, based on the current data received from the information obtaining unit 120 or the storing unit 130, in the above-described constant voltage charging period. To this end, the controller 140 may generate a graph of a charging time and a current of the battery cell 11 based on the current data, classify the current data, and analyze the generated graph.

Referring to FIG. 3, the controller 140 may generate a graph indicating data of the battery cell 11 in the constant voltage charging period. That is, the controller 140 may generate, based on the data of the battery cell 11 in the constant voltage charging period, a graph in which a first axis indicates time and a second axis indicates a current, a voltage, and a temperature. According to an embodiment, the first axis of the graph is an x axis and the second axis is a y axis. According to an embodiment, the origin of the graph may be a start point of the constant voltage charging period, and an end point of the first axis of the graph may be an end point of the constant voltage charging period.

In the constant voltage charging period, the power supplying unit 110 maintains the voltage of the battery cell 11 constant, such that the voltage of the battery cell 11 may be a constant value on the graph generated by the controller 140. That is, the voltage of the battery cell 11 may be maintained constant from the charging start timepoint to the charging end timepoint of the constant voltage charging period.

In the constant voltage charging period, the power supplying unit 110 maintains the voltage of the battery cell 11 constant and constantly reduces the current supplied to the battery cell 11, such that the current of the battery cell 11 may tend to generally decrease on the graph generated by the controller 140.

According to an embodiment, in the constant voltage charging period, if lithium precipitation occurs inside the battery cell 11, the temperature of the battery cell 111 may sharply increase. This phenomenon may originate from energy conversion in which electric energy is converted into thermal energy by supply of current to lithium precipitated inside the battery cell 11. As the current is supplied to lithium, the current flowing to the battery cell 11 may increase in the constant voltage charging period. Such a phenomenon may cause a defect of the battery cell, and the battery cell 11 experiencing this phenomenon may be an abnormal battery. That is, when the current flowing to the battery cell 11 increases in the constant voltage charging period, the battery cell 11 may be a defective battery inside which lithium is precipitated. Thus, the controller 140 may diagnose the state of the battery cell 11 based on the current data of the battery cell 11.

However, the current data of the battery cell 11 may include various noises such as noise in current measurement, noise in a charger/discharger, etc., such that for accurate diagnose of the battery cell 11, an influence of noise included in the current data needs to be removed. That is, current supplied to the battery cell 11 in the constant voltage charging period of the normal battery cell 11 generally decreases gradually, but there is a risk that the current increases in some periods due to an influence of noise, requiring removal of the influence of the noise. To this end, the controller 140 may appropriately set a time interval between two timepoints for comparison of the current data. The controller 140 may classify the current data of the battery cell 11 into a direct current component and an alternating current component to set the time interval of the two timepoints, and set the time interval between the two timepoints based on the alternating current component.

Referring to FIG. 4, the controller 140 may generate a moving average line 203 of the current data based on the current data of the battery cell 11. Herein, the moving average line 203 may be defined as a line formed by sequentially connecting arithmetic average values of the current data of the battery cell 11 for a certain period of time. The controller 140 may define the moving average line 203 of the current data as a direct current component of the current data.

Referring to FIG. 5, the controller 140 may use the moving average line 203 to classify the current data into the direct current component and the alternating current component. According to an embodiment, the controller 140 may extract the alternating current component of the current data based on a difference between the current data and the moving average line 203 of the current data. That is, the controller 140 may calculate the difference between the current value included in the current data and the value indicated by the moving average line 203 of the current data every charging time, and connect the difference to extract the alternating current component of the current data corresponding to each charging time. That is, the controller 140 may define the difference between the current data and the moving average line 203 of the current data as the alternating current component of the current data. According to an embodiment, the difference between the current data and the moving average line 203 of the current data may correspond to the alternating current component, such that a center value of the alternating current component may be 0.

The controller 140 may calculate a standard deviation of the alternating current component of the current data. Herein, the standard deviation may be defined as a value indicating a scatter diagram based on a difference between the alternating current component of the current data at each timepoint and the average of the alternating current components. That is, by squaring the difference between the alternating current component at each timepoint and the average of the alternating current components, summing them, and dividing the summation result by the number of timepoints, a square root of the division result may be defined as the standard deviation.

In the constant voltage charging period of the ideal battery cell 11, the power supplying unit 110 may apply the constant direct current voltage to the battery cell 11, such that the frequency of the power applied to the battery cell 11 from the power supplying unit 110 may be 0. As the frequency is 0, the impedance of the battery cell 11 may have a constant value, such that the current of the battery cell 11 may have the direct current component.

Thus, the alternating current component of the current data of the battery cell 11 may be defined as an influence of noise. According to an embodiment, the noise of the current data of the battery cell 11 may include noise in current measurement, noise in the charger/discharger, etc.

In the constant voltage charging period, the current data of the battery cells 11 may be measured as increasing in some periods due to the noise of the current data. Thus, in case of high noise, two timepoints may be selected with an interval in which noise is ignorable, and the current values at the two timepoints need to be compared. That is, for high noise, the interval between the two timepoints for comparison between the current data may be set to be greater than an interval for low noise.

To this end, the controller 140 may match the standard deviation of the alternating current component of the current data to the interval between the two timepoints for comparison between the current data. According to an embodiment, the controller 140 may set the standard deviation of the alternating current components to be proportional to the interval between the two timepoints, and generate a lookup table in which the standard deviation and the interval one-to-one correspond to each other. That is, the controller 140 may preset the lookup table that matches the standard deviation of the alternating current component with the interval between the two timepoints and calculate the standard deviation of the alternating current component of the battery cell 11, thereby obtaining the interval between the two timepoints, corresponding to the calculated standard deviation, on the lookup table.

Referring back to FIG. 3, the controller 140 may diagnose the state of the battery cell 11 based on the graph generated for the data of the battery cell 11 in the constant voltage charging period. The controller 140 may set a first timepoint defined on a time axis of the graph and a second timepoint having elapsed from the first timepoint by a predetermined time. According to an embodiment, the controller 140 may set the first timepoint as an origin and set the second timepoint as a timepoint having elapsed from the first timepoint by the interval between the two timepoints, obtained in FIG. 5. The interval between the first timepoint and the second timepoint on the graph may be the interval obtained in FIG. 5, and the interval between the first timepoint and the second timepoint may be defined as d.

In a current line 200 of the graph, a point corresponding to the first timepoint may be defined as a first point 201. In the current line 200 of the graph, a point corresponding to the second timepoint may be defined as a second point 202. In a temperature line 300 of the graph, a point corresponding to the first timepoint may be defined as a third point 301. In the current line 200 of the graph, a point corresponding to the second timepoint may be defined as a fourth point 302.

The controller 140 may compare a current value at the first point 201 with a current value at the second point 202. As time passes while the power supplying unit 110 maintains the voltage of the battery cell 11 as a constant voltage, the current supplied to the battery cell 11 gradually decreases, such that the current value at the second point 202 may be less than the current value at the first point 201. As such, if the current value at the second point 202 is less than the current value at the first point 201, the temperature of the battery may decrease. That is, the temperature value at the fourth point 302 may be less than the temperature value at the third point 301.

If the controller 140 determines that the current value at the second point 202 is less than the current value at the first point 201, the controller 140 may determine whether the second timepoint is the end point of the constant voltage charging period. That is, the controller 140 may determine whether the second timepoint is the charging end timepoint. In this case, if the controller 140 determines that the second timepoint is the end point of the constant voltage charging period, the controller 140 may complete diagnosis of the battery cell 11. If the controller 140 determines that the second timepoint is not the end point of the constant voltage charging period, the controller 140 may change the first timepoint and the second timepoint while maintaining the interval between the first timepoint and the second timepoint. According to an embodiment, the controller 140 may change the first timepoint and the second timepoint into timepoints having added thereto a preset time, respectively.

As the controller 140 changes the first timepoint and the second timepoint, the first point 201 corresponding to the first timepoint in the current line 200, the second point 202 corresponding to the second timepoint in the current point 200, the third point 301 corresponding to the first timepoint in the temperature line 300, and the fourth point 302 corresponding to the second timepoint in the temperature line 300 may also be changed.

The controller 140 may compare the current values at the first point 201 and the second point 202, newly defined by changing the first timepoint and the second timepoint, with each other. According to an embodiment, if the current value at the second point 202 is greater than the current value at the first point 201, the controller 140 may determine that the battery cell 11 is abnormal. That is, if the current value at the second point 202 is greater than the current value at the first point 201, it may mean that there is a period in which the current value increases over time, in the constant voltage charging period, such that the controller 140 may determine that the battery cell 11 is abnormal. In this case, lithium precipitation may occur inside the battery cell 11 and the current may be supplied to the precipitated lithium, such that electric energy is converted into thermal energy and thus the battery cell 11 generates heat. Thus, the temperature value at the fourth point 302 may be greater than the temperature value at the third point 301.

The controller 140 may repeat an operation of comparing the current value at the first point 201 with the current value at the second point 202 and changing the first timepoint and the second timepoint. In this way, the controller 140 may analyze the state of current over the entire constant voltage charging period and determine that the current increases due to lithium precipitation inside the battery cell 11.

Thus, the battery diagnosis apparatus 100 including the controller 140 may diagnose the state of the battery cell 11 by analyzing the current data of the constant voltage charging period. If the battery cell 11 is identified as abnormal as a result of diagnosis, the controller 140 may provide information about an abnormal battery cell to a user. For example, the controller 140 may provide information about an abnormal battery cell to a user terminal through a communication unit (not shown) and provide the information about the abnormal battery cell through a display provided in a vehicle, a charger, etc.

Hence, as the battery diagnosis apparatus 100 analyzes the current data of the battery cell 11, early detection of the abnormal battery cell 11 and replacement of the battery cell 11 may be possible and fire caused by heat generation of the battery cell 11 may be prevented.

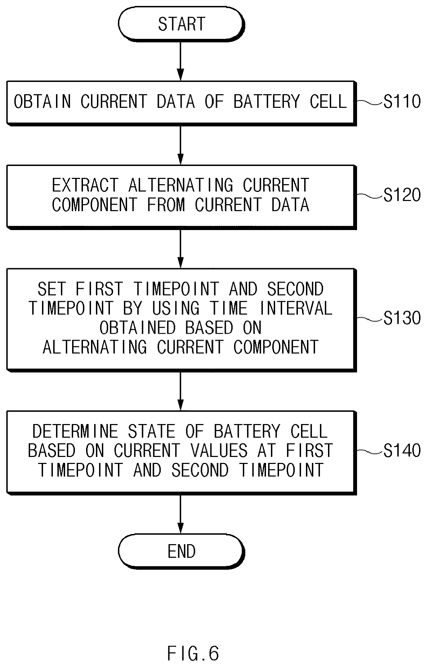

FIG. 6 is a flowchart of a battery diagnosis method according to an embodiment disclosed herein.

The embodiment shown in FIG. 6 may be an example, and an order of operations according to various embodiments of the present disclosure may be different from that shown in FIG. 6, and some operations shown in FIG. 6 may be omitted, the order of the operations may be changed, or the operations may be merged.

Referring to FIG. 6, the battery diagnosis method may include operation S110 of obtaining current data of a battery cell, operation S 120 of extracting an alternating current component from the current data, operation S130 of setting a first timepoint and a second timepoint by using a time interval obtained based on the alternating current component, and operation S140 of determining a state of the battery cell based on current values at a first timepoint and a second timepoint.

Hereinbelow, operations S110 through S140 will be described in detail with reference to FIGS. 1 to 5.

In operation S110, the battery diagnosis apparatus 100 may obtain current data of the battery 11.

According to an embodiment, the battery diagnosis apparatus 100 may obtain voltage data and temperature data of the battery cell 11 over time as well as the current data of the battery cell 11. That is, the battery diagnosis apparatus 100 may measure a voltage at opposite terminals of the battery cell 11, a current flowing to the battery cell 11, and a temperature of the battery cell 11. To this end, the battery diagnosis apparatus 100 may be connected to the battery cell 11.

The battery diagnosis apparatus 100 may generate a graph indicating data of the battery cell 11 in the constant voltage charging period. That is, the battery diagnosis apparatus 100 may generate, based on the data of the battery cell 11 in the constant voltage charging period, a graph in which a first axis indicates time and a second axis indicates a current, a voltage, and a temperature. According to an embodiment, the first axis of the graph is an x axis and the second axis is a y axis. According to an embodiment, the origin of the graph may be a start point of the constant voltage charging period, and an end point of the first axis of the graph may be an end point of the constant voltage charging period.

After operation S110, operation S120 may be performed.

In operation S120, the battery diagnosis apparatus 100 may extract an alternating current component from the current data. To this end, the battery diagnosis apparatus 100 may generate a moving average line 203 of the current data based on the current data of the battery cell 11. The battery diagnosis apparatus 100 may define the moving average line 203 of the current data as a direct current component of the current data. That is, the battery diagnosis apparatus 100 may use the moving average line 203 to classify the current data into the direct current component and the alternating current component.

The battery diagnosis apparatus 100 may extract the alternating current component of the current data based on a difference between the current data and the moving average line 203 of the current data. That is, the battery diagnosis apparatus 100 may calculate the difference between the current value included in the current data and the value indicated by the moving average line 203 of the current data every charging time, and connect the difference to extract the alternating current component of the current data corresponding to each charging time. That is, the battery diagnosis apparatus 100 may define the difference between the direct current data and the moving average line 203 of the direct current data as the alternating current component of the current data. According to an embodiment, the difference between the current data and the moving average line 203 of the current data may correspond to the alternating current component, such that a center value of the alternating current component may be 0.

After operation S120, operation S130 may be performed.

In operation S130, the battery diagnosis apparatus 100 may set the first timepoint and the second timepoint by using the time interval obtained based on the alternating current component.

The battery diagnosis apparatus 100 may calculate a standard deviation of the alternating current component of the current data. In the constant voltage charging period of the ideal battery cell 11, the power supplying unit 110 may apply the constant direct current voltage to the battery cell 11, such that the frequency from the power supplying unit 110 may be 0. As the frequency is 0, the impedance of the battery cell 11 may have a constant value, such that the current of the battery cell 11 may have the direct current component.

Thus, the alternating current component of the current data of the battery cell 11 may be an influence of noise. According to an embodiment, the noise of the current data of the battery cell 11 may include noise in current measurement, noise in the charger/discharger, etc.

In the constant voltage charging period, the current data of the battery cells 11 may be measured as increasing in some periods due to the noise of the current data. Thus, in case of high noise, two timepoints may be selected with an interval in which noise is ignorable, and the current values at the two timepoints need to be compared. That is, for high noise, the interval between the two timepoints for comparison between the current data may be greater than an interval for low noise.

To this end, the battery diagnosis apparatus 100 may match the standard deviation of the alternating current component of the current data to the interval between the two timepoints for comparison between the current data. According to an embodiment, the battery diagnosis apparatus 100 may set the standard deviation of the alternating current components to be proportional to the interval between the two timepoints, and generate a lookup table in which the standard deviation and the interval one-to-one correspond to each other. That is, the battery diagnosis apparatus 100 may preset the lookup table that matches the standard deviation of the alternating current component with the interval between the two timepoints and calculate the standard deviation of the alternating current component of the battery cell 11, thereby obtaining the interval between the two timepoints, corresponding to the calculated standard deviation, on the lookup table.

After operation S130, operation S140 may be performed.

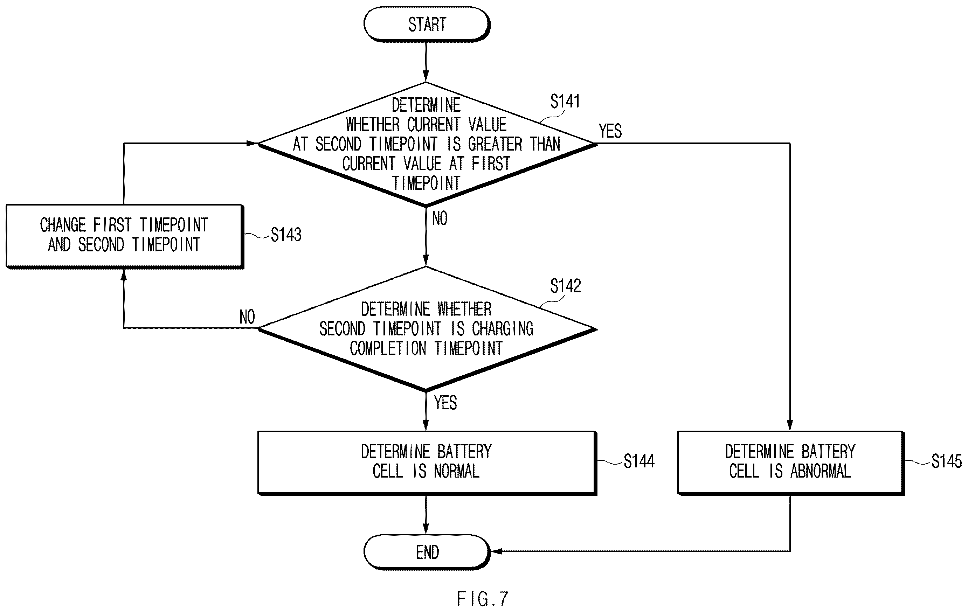

In operation S110, the battery diagnosis apparatus 100 may determine the state of the battery cell 11 based on the current values at the first timepoint and the second timepoint. The battery diagnosis apparatus 100 may determine the state of the battery cell 11 by comparing the current value corresponding to the first timepoint with the current value corresponding to the second timepoint. This will be described in detail with reference to FIG. 7.

FIG. 7 is a flowchart showing in detail an operation of determining the state of the battery cell 11 based on the current values at the first timepoint and the second timepoint of FIG. 6.

Referring to FIG. 7, the operation of determining the state of the battery cell based on the current values at the first timepoint and the second timepoint may include operation S141 of determining whether the current value at the second timepoint is greater than the current value at the first timepoint, operation S142 of determining whether the second timepoint is a charging completion timepoint, operation S143 of changing the first timepoint and the second timepoint, operation S144 of determining the battery cell is normal, and operation S145 of determining the battery cell is abnormal.

In operation S141, the battery diagnosis apparatus 100 may set the first timepoint defined on the time axis of the graph and the second timepoint having elapsed from the first timepoint by a predetermined time. According to an embodiment, the battery diagnosis apparatus 100 may set the first timepoint as an origin and set the second timepoint as a timepoint having elapsed from the first timepoint by the interval between the two timepoints, obtained in FIG. 5.

In a current line 200 of the graph, a point corresponding to the first timepoint may be defined as a first point 201. In the current line 200 of the graph, a point corresponding to the second timepoint may be defined as a second point 202.

The battery diagnosis apparatus 100 may compare a current value at the first point 201 with a current value at the second point 202. Herein, the battery diagnosis apparatus 100 may compare the current value at the first point 201 with the current value at the second point 202. If the battery diagnosis apparatus 100 determines that the current value at the second timepoint is greater than the current value at the first timepoint, operation S145 may be performed. If the battery diagnosis apparatus 100 determines that the current value at the second timepoint is less than the current value at the first timepoint, operation S142 may be performed.

In operation 142, the battery diagnosis apparatus 100 may determine whether the second timepoint is a charging completion timepoint. That is, if the battery diagnosis apparatus 100 determines that the current value at the second point 202 is less than the current value at the first point 201, the controller 140 may determine whether the second timepoint is the end point of the constant voltage charging period.

If the battery diagnosis apparatus 100 determines that the second timepoint is the charging completion timepoint, operation S114 may be performed. If the battery diagnosis apparatus 100 determines that the second timepoint is not the charging completion timepoint, operation S143 may be performed.

In operation S143, the battery diagnosis apparatus 100 may change the first timepoint and the second timepoint. That is, the battery diagnosis apparatus 100 may change the first timepoint and the second timepoint by adding a preset time to each of the first timepoint and the second timepoint while maintaining an interval between the first timepoint and the second timepoint.

After operation S143, operation S141 may be performed.

In operation S144, the battery diagnosis apparatus 100 may determine that the diagnosis target battery cell 11 is normal. As a result of diagnosis from the constant voltage charging timepoint to the charging end point of the battery cell 11 while changing the first timepoint and the second timepoint, if the current value of the battery cell 11 corresponding to the first timepoint is greater than the current value of the battery cell 11 corresponding to the second timepoint, the battery diagnosis apparatus 100 may determine that the battery cell 11 is normal.

In operation S145, the battery diagnosis apparatus 100 may determine that the diagnosis target battery cell 11 is abnormal. That is, if the battery diagnosis apparatus 100 determines that the current value at the second timepoint is greater than the current value at the first timepoint, the battery diagnosis apparatus 100 may determine that the battery cell 11 is abnormal.

That is, if the current value at the second point 202 is greater than the current value at the first point 201, it may mean that there is a period in which the current value increases over time, in the constant voltage charging period, such that the battery diagnosis apparatus 100 may determine that the battery cell 11 is abnormal. In this case, lithium precipitation may occur inside the battery cell 11 and the current may be supplied to the precipitated lithium, such that electric energy is converted into thermal energy and thus the battery cell 11 generates heat. Accordingly, the temperature of the battery cells 11 may rise sharply.

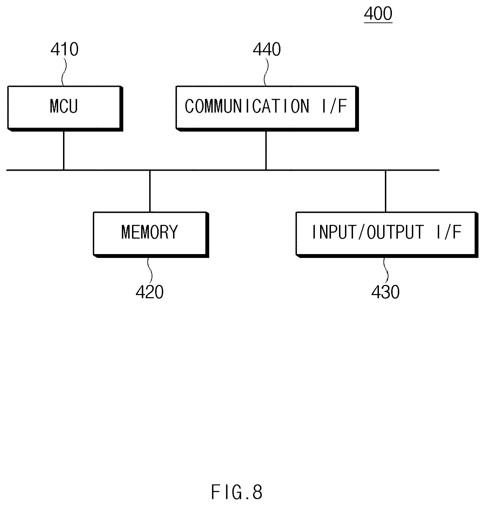

FIG. 8 illustrates a computing system that executes a battery diagnosis method, according to an embodiment disclosed herein.

Referring to FIG. 8, a computing system 400 according to an embodiment disclosed herein may include an MCU 410, a memory 420, an input/output I/F 430, and a communication I/F 440.

The MCU 410 may be a processor that executes various programs (e.g., an SOH calculation program, a cell balancing target determination program, etc.) stored in the memory 420, processes various data including an SOC, an SOH, etc., of the plurality of battery cells through these programs, and executes the above-described functions of the battery diagnosis apparatus 100 described with reference to FIGS. 1 to 7. The MCU 410 may be a BMS, a separate PC, or a cloud, without being limited thereto.

The memory 420 may store various programs regarding SOH calculation of the battery cell, cell balancing target determination, etc. Moreover, the memory 420 may store various data such as SOC data, SOH data, etc., of each battery cell.

The memory 420 may be provided in plural, depending on a need. The memory 420 may be volatile memory or non-volatile memory. For the memory 420 as the volatile memory, random access memory (RAM), dynamic RAM (DRAM), static RAM (SRAM), etc., may be used. For the memory 420 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 420 are merely examples and are not limited thereto.

The input/output I/F 430 may provide an interface for transmitting and receiving data by connecting an input device (not shown) such as a keyboard, a mouse, a touch panel, etc., and an output device such as a display (not shown), etc., to the MCU 410.

The communication I/F 440, which is a component capable of transmitting and receiving various data to and from a server, may be various devices capable of supporting wired or wireless communication. For example, a program for SOH calculation of the battery cell or balancing target determination or various data, etc., may be transmitted and received to and from a separately provided external server through the communication I/F 440.

As such, the battery management method according to an embodiment disclosed herein may be recorded in the memory 420 and executed by the MCU 410.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery diagnosis apparatus comprising:
an information obtaining unit configured to obtain current data of a battery cell; and
a controller configured to obtain the current data in a constant voltage charging period of the battery cell, set a first timepoint at which the current data is obtained and a second timepoint at which the current data is obtained after an elapse of a predetermined time from the first timepoint, and determine a state of the battery cell based on current values at the first timepoint and the second timepoint.

2. The battery diagnosis apparatus of claim 1, wherein the controller is further configured to determine the battery cell is an abnormal battery cell if the current value at the second timepoint is greater than the current value at the first timepoint.

3. The battery diagnosis apparatus of claim 2, wherein the controller is further configured to change the first timepoint and the second timepoint while maintaining a time interval between the first timepoint and the second timepoint and compare the current value at the first timepoint with the current value at the second timepoint.

4. The battery diagnosis apparatus of claim 2, wherein the abnormal battery cell comprises a battery cell in which lithium (Li) is precipitated.

5. The battery diagnosis apparatus of claim 1, wherein the controller is further configured to classify the current data into a direct current component and an alternating current component by using a moving average of the current data.

6. The battery diagnosis apparatus of claim 5, wherein the controller is further configured to remove the direct current component from the current data to extract the alternating current component.

7. The battery diagnosis apparatus of claim 6, wherein the controller is further configured to calculate a standard deviation of the alternating current component, and
set the time interval between the first timepoint and the second timepoint based on the standard deviation.

8. The battery diagnosis apparatus of claim 1, further comprising a storing unit configured to store the current data of the battery cell, measured by the information obtaining unit.

9. A battery diagnosis method comprising:
obtaining current data of a battery cell in a constant voltage charging period of the battery cell;
setting a first timepoint at which the current data is obtained and a second timepoint at which the current data is obtained after an elapse of a predetermined time from the first timepoint; and
determining a state of the battery cell based on current values at the first timepoint and the second timepoint.

10. The battery diagnosis method of claim 9, wherein the determining of the state of the battery cell comprises determining the battery cell is an abnormal battery cell if the current value at the second timepoint is greater than the current value at the first timepoint.

11. The battery diagnosis method of claim 10, wherein the abnormal battery cell comprises a battery cell in which lithium (Li) is precipitated.

12. The battery diagnosis method of claim 9, wherein the determining of the state of the battery cell comprises generating, based on the current data, a graph in which a first axis is time and a second axis is a current value, changing the first timepoint and the second timepoint while maintaining a time interval between the first timepoint and the second timepoint, and comparing the current value at the first timepoint with the current value at the second timepoint.

13. The battery diagnosis method of claim 9, wherein the setting of the time interval comprises classifying the current data into a direct current component and an alternating current component by using a moving average of the current data.

14. The battery diagnosis method of claim 13, wherein the setting of the time interval comprises removing the direct current component from the current data to extract the alternating current component.

15. The battery diagnosis method of claim 14, wherein the setting of the time interval comprises calculating a standard deviation of the alternating current component, and setting the time interval between the first timepoint and the second timepoint based on the standard deviation.
